(19) **Europäisches Patentamt European Patent Office Office européen des brevets**

(11) **EP 1 470 641 B1**

(12) **FASCICULE DE BREVET EUROPEEN**

(45) Date de publication et mention
de la délivrance du brevet:
**30.12.2009 Bulletin 2009/53**

(21) Numéro de dépôt: **03717336.6**

(22) Date de dépôt: **10.01.2003**

(51) Int Cl.:
*H03H 11/34* *(2006.01)*    *H04B 1/58* *(2006.01)*

(86) Numéro de dépôt international:
**PCT/FR2003/000066**

(87) Numéro de publication internationale:
**WO 2003/061121 (24.07.2003 Gazette 2003/30)**

(54) **DISPOSITIF DE FILTRAGE PASSE-BAS DESTINÉ AU DÉCOUPLAGE DES VOIES XDSL**

TIEFPASSFILTERANORDNUNG ZUR ENTKOPPLUNG VON XDSL KANÄLEN

LOW-PASS FILTERING DEVICE FOR COUPLING XDSL CHANNELS

(84) Etats contractants désignés:
**AT BE BG CH CY CZ DE DK EE ES FI FR GB GR HU IE IT LI LU MC NL PT SE SI SK TR**

(30) Priorité: **10.01.2002 FR 0200269**

(43) Date de publication de la demande:
**27.10.2004 Bulletin 2004/44**

(73) Titulaire: **Laboratoire Europeen ADSL Leacom Fastnet
92400 Courbevoie (FR)**

(72) Inventeurs:
• **BERTHAUD, Eric
F-35380 Reugny (FR)**
• **DEDIEU, Hervé
F-35500 Vitre (FR)**

(74) Mandataire: **Camus, Olivier Jean-Claude et al
SCHMIT CHRETIEN
8, place du Ponceau
95000 Cergy (FR)**

(56) Documents cités:
**EP-A- 0 967 735    EP-A- 1 005 209**

EP 1 470 641 B1

Printed by Jouve, 75001 PARIS (FR)

**Description**

La présente invention a pour objet un dispositif de filtrage passe-bas destiné au découplage des voies xDSL. Elle est destinée à être incorporée dans un dispositif séparateur de signaux voix-données pour une transmission sur des voies xDSL. Elle propose une nouvelle conception de filtres, qui sont ainsi rendus moins coûteux et moins volumineux que ceux utilisés dans l'état de la technique.

Le domaine de l'invention est, d'une façon générale, celui des technologies dites xDSL. Dans ces technologies, on trouve par exemple la technologie ADSL (pour Asymetric Digital Subscriber Line, en anglais, pour ligne d'abonné numérique à débit asymétrique), la technologie VDSL (pour Very-high-data rate Digital Suscriber Line, pour ligne d'abonné numérique à très haut débit), ou encore les technologies HDSL ou SDSL. L'invention sera plus particulièrement décrite, à titre d'exemple, dans le cadre de l'ADSL. Elle peut cependant également être utilisée avec les autres technologies xDSL. Ces technologies sont essentiellement mises en oeuvre sur des boucles locales des réseaux de téléphonie existant, la boucle locale étant constituée par les intermédiaires du réseau entre un central téléphonique et un poste d'abonné. Un des objectifs essentiels de ces technologies est de rendre possible, sur les boucles locales des anciens réseaux de téléphonie, la transmission simultanée de différents types de signaux : d'une part, les signaux relatifs aux conversations téléphoniques habituelles entre deux abonnés, ces premiers signaux comprenant des signaux relatifs à la voix et des signaux de signalisation, et d'autre part, des signaux relatifs à des données, typiquement des informations échangées entre un abonné et un site accessible via le réseau Internet.

Pour des transmissions selon ces technologies, on utilise donc la paire de fils de cuivre qui arrive chez l'abonné, et qui constitue depuis longtemps la ligne téléphonique, ou boucle d'abonné, à laquelle sont raccordés les différents combinés téléphoniques de l'utilisateur des réseaux analogiques traditionnels dits POTS (pour Plain Old Transmission System - système ancien de télécommunications) ou des réseaux numériques traditionnels dits ISDN (ou RNIS - réseau numérique à intégration de services). Cette paire de fils de cuivre est le plus souvent torsadée et comporte une gaine isolante en polyéthylène.

Sur cette paire de fils de cuivre, on transmet donc à la fois :

- en bande de base, des signaux analogiques non modulés correspondant aux réseaux POTS, ou des signaux numériques correspondant aux réseaux ISDN. Les signaux analogiques en bande de base sont de fréquence typiquement 0 à 4 kHz, ou 0 à 16 KHz si on tient compte des signaux de signalisation. Les signaux numériques en bande de base sont dans des fréquences de 0 à 94 KHz. En pratique, la bande de base est destinée à une transmission en mode circuit;
- en bande haute fréquence, d'autres signaux, numériques et modulés, qui correspondent par exemple aux informations échangées avec le réseau Internet. La bande haute s'étale du dessus de la bande de base téléphonique jusqu'à 1 MHz environ. En pratique la bande haute fréquence s'étale de 32 KHz à 1,1MHz si la paire de fils de cuivre sert en bande de base pour une transmission analogique POTS, et de 138 KHz à 1,1 MHz si elle sert pour une transmission numérique. Elle est normalement destinée à une transmission permanente, en mode paquets principalement, c'est à dire qu'une communication permanente est établie entre l'abonné et le central téléphonique. On est ainsi dispensé des opérations classiques intervenant lors d'une connexion avec accès par ligne commutée, qui est une méthode de connexion temporaire à un réseau informatique consistant à utiliser un modem, un logiciel de connexion et le réseau téléphonique commuté comme moyen de mise en communication de son propre ordinateur et d'un autre ordinateur du réseau.

Bien que la bande de base puisse être utilisée, notamment avec des modems de préférence numériques, pour transmettre des données, et que la bande haute fréquence puisse servir à assurer des communications phoniques dans le cadre de communications dites communications téléphoniques sur Internet, on considérera, de façon schématique, et dans un souci de simplification des explications, que la bande de base est utilisée pour la transmission d'un premier type de signaux, essentiellement des paroles, correspondant à des communications phoniques, et que la bande haute fréquence sert pour la transmission d'un deuxième type de signaux, essentiellement des données, relatives notamment à la consultation de sites Internet.

La bande de base n'est capable que d'un faible débit (actuellement 56 Kbits/s pour les modems analogiques et 64 Kbits/s pour les modems numériques) alors que la bande haute fréquence est susceptible de présenter un haut débit (pouvant avoisiner 10 Mbits/s).

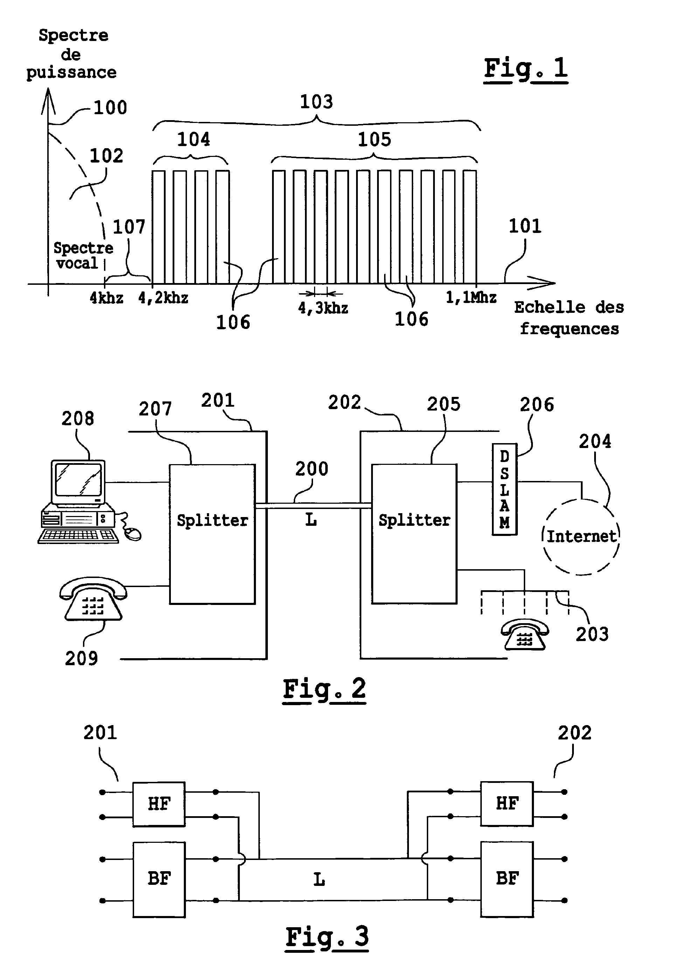

La figure 1 illustre l'exploitation de la bande de fréquence en distribution ADSL. L'axe des ordonnées 100 échelonne la puissance des signaux émis, et l'axe des abscisses 101 donne l'échelle des fréquences. Les puissances émises sont représentées de façon équirépartie dans un but de simplification. On retrouve le spectre vocal 102 s'étendant approximativement de 0 à 4 kHz, et le spectre 103 utilisé pour la transmission de données selon la technologie ADSL, ce dernier s'étendant d'environ 30 kHz à 1,1 MHz. Entre le spectre 102 et le spectre 103 se trouve une bande d'énergie inutilisée 107, à l'exception éventuellement de signaux de taxation pouvant être présents à 12 kHz ou à 16 kHz. Le spectre 103 est divisé en deux parties principales : une première bande de fréquence 104 correspondant au spectre utilisé pour les données montantes (de l'abonné vers le central) et une deuxième bande de fréquence 105 correspondant au spectre utilisé pour les données descendantes (du central vers l'abonné). La deuxième bande de fréquence 105 est plus large que la première bande de fréquence 104 car les données montantes, qui correspondent le plus souvent à des requêtes émises par un abonné, sont le plus souvent moins nombreuses que les données descendantes, qui peuvent correspondre au téléchargement de gros fichiers, des images par exemple.

Un modem répartit le spectre 103 en 256 sous-bandes 106 de 4,3125 kHz dédiées à des porteurs indépendants qui optimisent le débit à transmettre en fonction des performances du canal alloué. Les porteuses inférieures ne sont pas mises en oeuvre afin de permettre la transmission analogique de la téléphonie dans la bande de base. Lors de l'installation du modem ADSL, n'importe quelle porteuse peut être activée, en fonction de l'état de la ligne. Le nombre de bits codés par modulation DMT (pour Discrete Multitone en anglais) ou CAP (pour Carrierless Amplitude and Phase en anglais) par porteuse dépend de la qualité de la ligne dans la bande de fréquence considérée, la granularité de débit étant assurée par paliers de 32 kbits/s, de 6 à 8 Mbits/s.

L'utilisation d'une ligne dite ADSL nécessite donc de séparer la bande de base, basse fréquence, de la bande haute fréquence. La figure 2 illustre schématiquement ces séparations au niveau d'une boucle locale de communication. Sur cette figure, on a représenté une ligne téléphonique usuelle 200, ou boucle d'abonné, composée de deux fils en cuivre, qui assure la liaison entre un abonné 201 et un central téléphonique 202.

Le central téléphonique 202 assure la connexion à un réseau de téléphonie classique 203 et à un réseau de type Internet 204. Afin de dissocier les signaux destinés au réseau téléphonique 203 et au réseau Internet 204, un premier dispositif 205 séparateur de signaux voix-données, également appelé filtre à aiguillage ou splitter, est utilisé. D'une façon générale, un splitter est un dispositif électronique associé à un modem ADSL qui permet de séparer les signaux de la voix des signaux de données et de les acheminer sur deux voies différentes. Le splitter 205 sera désigné par la suite comme splitter central.

Le splitter central 205 est le plus souvent incorporé dans une carte de splitter, cette carte pouvant comporter jusqu'à quelques dizaines de splitters centraux. Il a pour fonction de séparer les signaux de données, qui sont orientés vers le réseau Internet 204, et les signaux de voix, qui sont orientés vers les réseaux de téléphonie classiques 203. Une autre fonction du splitter central 205 est de multiplexer les signaux de voix, émis par les réseaux de téléphonie classiques 203, et les signaux émis par un multiplexeur d'accès 206 ultérieurement détaillé, afin de les acheminer sur la même paire torsadée 200. En théorie, on trouve dans le splitter central 205 un filtre basse fréquence et un filtre haute fréquence, qui laissent passer respectivement les signaux phoniques et les signaux ADSL. La conception du splitter central 205 doit être telle que les services téléphoniques classiques des réseaux POTS et/ou ISDN ne soient pas perturbés par la présence des signaux ADSL, et que le flux de données des signaux ADSL ne soit pas affecté par certaines opérations classiques observables sur ces réseaux, notamment les opérations de décroché/raccroché.

Les données destinées au - ou provenant du - réseau Internet 204 transitent par un multiplexeur d'accès DSL 206, appelé DSLAM, qui est relié au splitter central 205. Un DSLAM (pour Digital Suscriber Line Access Multiplexer en anglais) est un multiplexeur d'accès, conçu spécialement pour les équipements DSL, habituellement situé dans les locaux des centraux téléphoniques, qui transmet les signaux sur Internet en utilisant une technique de multiplexage temporel. Dans certains cas, le DSLAM peut cependant se trouver hors du central téléphonique, afin de réduire la distance entre l'abonné et le DSLAM. En effet, la qualité de la transmission d'informations à haute fréquence sur les lignes téléphoniques est directement dépendante de la longueur de la ligne. Dans ce cas de figure, on prévoit de relier le DSLAM, installé dans un local particulier, au central téléphonique au moyen d'une fibre optique, et de relier par ailleurs le DSLAM au moyen d'une ligne téléphonique classique, composée de deux fils de cuivre, directement chez l'abonné.

Du côté de l'abonné 201, on trouve également un splitter 207 relié à la ligne téléphonique 200. Le splitter 207 est appelé splitter maître. Il a aussi pour fonction de séparer les signaux de données, qui sont orientés vers un ordinateur personnel 208 associé à un modem ADSL, et les signaux de voix, qui sont orientés vers des combinés téléphoniques classiques 209. En théorie, on trouve également dans le splitter maître 207 un filtre basse fréquence et un filtre haute fréquence, qui laissent passer respectivement les signaux phoniques et les signaux ADSL. La conception du splitter maître 207 doit être telle que, comme pour le splitter central 205, il doit pouvoir éviter tout phénomène d'interférence ou d'altération, pour chaque type de signaux, qui pourrait être causé par l'autre type de signaux.

Dans la pratique, le filtre basse fréquence du splitter et le filtre haute fréquence sont séparés : en effet, le filtre haute fréquence, c'est à dire le filtre qui laisse passer les signaux de données et uniquement ceux-là, est incorporé, partiellement ou totalement, dans un modem ADSL. En général, des capacités dites de blocage constituent un filtre passe-haut très sommaire protégeant les modems contre les courants continus de ligne. Comme représenté à la figure 3, une installation ADSL comporte donc deux paires de filtres, montés en parallèle côté central téléphonique 202 et côté abonné 201 sur les deux brins d'une ligne téléphonique L. Un premier filtre d'une paire est un filtre basse fréquence BF, le second est un filtre haute fréquence HF. Comme illustré à la figure 2, côté central téléphonique, le premier filtre est raccordé en amont à un multiplexeur-répartiteur de téléphonie classique, le second est raccordé à un DSLAM. Côté abonné, le premier filtre est raccordé au téléphone, le second est raccordé à un modem ADSL. Chaque filtre sert à isoler l'installation qu'il relie des signaux destinés à l'autre installation. Notamment, le filtre basse fréquence sert à empêcher que les signaux phoniques soient perturbés par les signaux de données. Un tel filtre, du côté central téléphonique comme du côté abonné, est l'objet de l'invention. Par abus de langage, on appelle de tels filtres également des "splitters".

Afin que la puissance transmise par la ligne téléphonique le soit avec le meilleur rendement possible, les lignes téléphoniques doivent être caractérisées, en entrée et en sortie, par une impédance ayant une valeur aussi proche que possible de l'impédance complexe caractéristique de la ligne téléphonique. On appelle Zc une telle impédance caractéristique. Dans la pratique Zc est une valeur imposée par une norme, la norme en question pouvant malheureusement être différente d'un pays à l'autre, même si les impédances concernées ont des valeurs sensiblement comparables. On trouve ainsi notamment l'impédance européenne harmonisée, l'impédance anglaise, l'impédance allemande, et deux impédances américaines dites à 600 ohms et 900 ohms respectivement. Les différences entre ces impédances dépendent notamment du diamètre des fils de cuivre utilisés, de l'isolant et du pas des torsades.

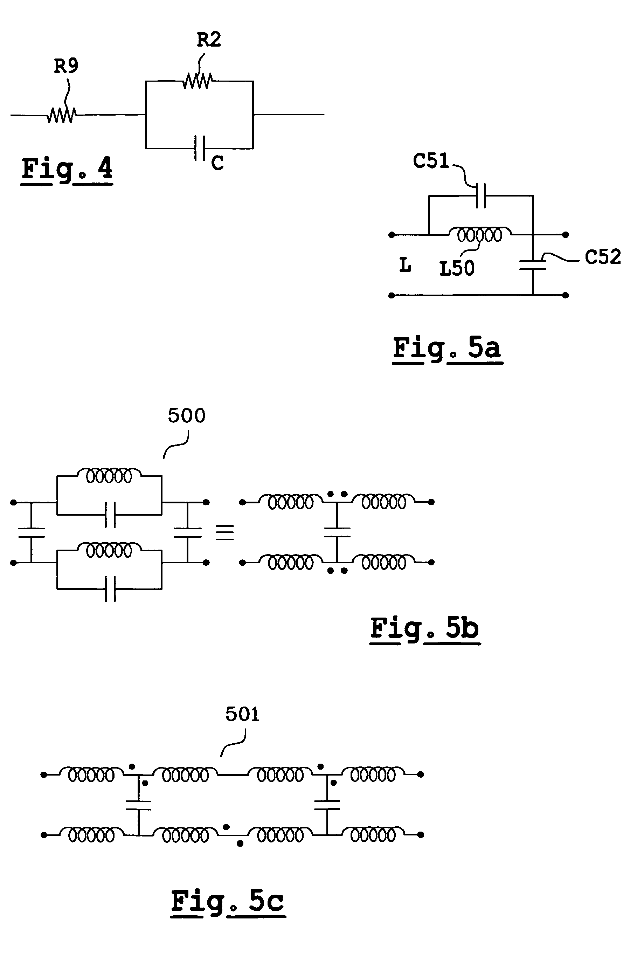

Typiquement, une impédance caractéristique peut être modélisée sous la forme représenté à la figure 4, sur laquelle une première résistance R1 est disposée en série avec une deuxième résistance R2, elle-même montée en parallèle avec un condensateur C. L'impédance équivalente à ce montage est $Zc=R1+R2*(1-jR2Cw)/(1+(R2Cw)^2)$, où w représente la pulsation d'un signal circulant sur la ligne téléphonique. Lors de l'insertion d'un splitter sur la ligne téléphonique, il convient de s'assurer que les impédances d'entrée et de sortie du splitter sont suffisamment proches de l'impédance caractéristique de ligne. On assure ainsi une meilleure transmission et on minimise chez l'abonné le phénomène d'écho local.

Par ailleurs, deux autres contraintes sont à prendre en compte pour la mise en oeuvre de ces technologies :

- le facteur dit d'affaiblissement d'insertion, ou ILF (pour Insertion Loss Factor en anglais), qui mesure un affaiblissement de puissance d'une voie de transmission lorsqu'il s'y trouve des montages en pont, des filtres, des égaliseurs ou d'autres montages. Dans le cas présent, ce facteur mesure la perte de transmission occasionnée dans le circuit par la mise en place d'un filtre, entre une situation où le filtre n'est pas présent et une situation où il est mis en place ; selon la plupart des normes en vigueur, cette perte doit être inférieure à 1 dB à 1 kHz. La distorsion d'atténuation devant être, en valeur absolue, inférieure à 1 dB par rapport à l'atténuation constatée à 1 kHz.
- le facteur dit d'affaiblissement de réflexion, ou RLF (pour Return Loss en anglais), qui est une mesure liée à la puissance de signal réfléchi par rapport à la puissance de signal transmissible. Il s'exprime par la formule suivante :

$$RLF=20 \log 10 \, abs(((Zin(w)+Zc(w)) / ((Zin(w)-Zc(w))),$$

où Zin(w) mesure l'impédance d'entrée du dispositif dont on veut mesurer le RLF, et où Zc(w) est l'impédance d'une charge de référence. On voit clairement que le Return Loss correspond à une mesure d'adaptation d'impédance. Lorsque l'adaptation est parfaite (Zin(w)=Zc(w)), le Return Loss tend vers l'infini. Dans les normes, l'affaiblissement de réflexion pour un filtre basse fréquence doit être supérieur à environ 18 dB dans la bande de base utile (300 - 3400 Hz en réseau POTS, et 300 - 94000 Hz en réseau ISDN).

Pour tenter de satisfaire à toutes ces contraintes, il a été imaginé différents type de filtres basse fréquence. Une des solutions préférées de l'état de la technique est l'utilisation de filtres elliptiques, également appelés filtres de Cauer. Ces filtres sont constitués d'une succession de cellules elliptiques, dont la structure de base est représentée figure 5a. Un des brins de la ligne téléphonique L comporte, montés en parallèle, une inductance L50 et une première capacité C51. Une deuxième capacité C52 est disposée entre les deux brins de la ligne L. Cette cellule basique est symétrisée pour s'adapter aux normes de la téléphonie, pour obtenir un filtre elliptique basique symétrique 500 tel que montré à la figure 5-b. Les composants présents sur chaque branche de transmission de la ligne ont la même valeur que leurs composants symétriques sur l'autre branche de transmission. La partie droite de la figure 5-b montre une réalisation préférée de la cellule duale elliptique théorique. Le filtre elliptique basique 500 est répété pour constituer un filtre 501, utilisé dans l'état de la technique, représenté sur la figure 5-c. Une autre réalisation possible de ces filtres est de regrouper deux à deux les inductances symétriques pour les coupler autour d'un même noyau magnétique pour en faire des transformateurs. On obtient au minimum un filtre avec quatre transformateurs. De tels filtres présentent notamment la caractéristique de ne pas avoir tous les pôles de leur fonction de transfert à l'infini, et de pouvoir limiter la bande d'énergie inutilisée 107 (voir figure 1) à une plage de fréquence étroite entre le spectre vocal 102 et le spectre utilisé pour les transmissions de données 103.

Cependant, de telles structures de filtres ne sont pas entièrement satisfaisantes. Elles présentent de nombreux inconvénients et/ou désavantages :

- tout d'abord, comme montré aux figures 5-a à 5-c, la structure des filtres elliptiques est composé des composants passifs non dissipatifs. Or la nature complexe des impédances caractéristiques, dont la partie imaginaire n'est plus négligeable avec les technologies xDSL, impose, pour obtenir un filtre optimal, d'introduire des correcteurs constitués de quelques résistances et/ou capacités négatives. De tels correcteurs doivent donc faire appel à des composants actifs qui ne sont pas présents dans les filtres de la figure 5-c.

- les exigences des différentes normes en terme de niveau de réjection des signaux ADSL et de return loss impliquent la présence, comme on l'a vu, d'au moins quatre transformateurs au sein du filtre basse fréquence. Ceci a pour conséquence d'une part un coût non négligeable dans la réalisation des filtres, et, d'autre part, du fait de la grande variabilité du marché de la ferrite, des périodes de pénurie parfois importantes.

- du fait du nombre important de bobines utilisées dans les filtres de l'état de la technique, l'espace occupé par chaque splitter est de l'ordre de 15 à 20 cm$^2$. Cet encombrement n'est pas négligeable, essentiellement du côté central téléphonique où de nombreux splitters sont montés ensemble sur une même carte.

- les performances des filtres passifs peuvent varier sensiblement d'un filtre à l'autre du fait de la tolérance des inductances utilisées, qui est de l'ordre de plus ou moins 7%.

Un des objets essentiels de l'invention est de proposer un filtre passe-bas qui s'affranchit des inconvénients qui viennent d'être exposés. A cet effet, le filtre passe-bas selon l'invention est réalisé en partie sous la forme d'un circuit intégré Les filtres de Cauer de l'état de la technique sont, dans l'invention, remplacés essentiellement par des ASIC (Application Specific Integrated Circuit en anglais pour circuit intégré à application spécifique). Dans l'invention, pour respecter la symétrie des lignes téléphoniques, on dispose un ASIC sur chaque brin de la ligne téléphonique, les deux ASIC présentant une topologie similaire. Quelques éléments passifs sont, de préférence, encore présents dans le filtre basse fréquence de l'invention. Un premier ensemble d'éléments passifs peut permettre de limiter la tension aux bornes des ASIC, un deuxième ensemble d'éléments passifs pouvant être utilisés pour réaliser un bloc correcteur d'impédance entre les deux ASIC.

Des caractéristiques particulières ont été prises en compte pour la réalisation du filtre selon l'invention : tout d'abord, aucune alimentation supplémentaire n'est nécessaire pour le fonctionnement des ASIC du filtre selon l'invention. La conception du filtre est telle que le courant continu circulant dans la boucle locale de la ligne téléphonique suffit pour alimenter les ASIC. Le fait de ne requérir aucune alimentation extérieure supplémentaire vient également du fait que les ASIC utilisés dans le filtre selon l'invention sont des ASIC analogiques. Le fait d'utiliser de tels ASIC facilite par ailleurs la circulation bidirectionnelle des signaux. En effet, une présence d'ASIC numériques au sein du filtre selon l'invention, outre le fait que leur consommation est plus importante, aurait nécessité la présence de transformateurs hybrides 2 fils - 4 fils. Les ASIC proposés font notamment appel à une technologie CMOS à faible coût.

L'invention concerne donc essentiellement un dispositif de filtrage passe-bas utilisé sur une ligne téléphonique composée d'une première ligne de transmission et d'une deuxième ligne de transmission, susceptible de faire circuler simultanément, entre un central téléphonique et un abonné équipé d'au moins un téléphone, des premiers signaux correspondant à des services bande étroite analogique et/ou numérique, et des seconds signaux correspondant à des services large bande **caractérisé en ce qu**'il comporte une partie active, constituée d'un premier élément actif de type ASIC, disposé en série sur la première ligne de transmission et d'un deuxième élément actif de type ASIC disposé en série sur la deuxième ligne de transmission, la partie active étant associée à une partie passive comportant notamment un premier élément passif et un deuxième élément passif de type inductance également disposés en série respectivement sur la première ligne de transmission et sur la deuxième ligne de transmission de la ligne, les inductances précédant, du côté ligne, chaque élément actif.

Dans des modes de réalisation particuliers du dispositif selon l'invention, la partie passive peut comporter une première capacité disposée, du côté ligne, en parallèle entre les deux lignes de transmission de la ligne, et/ou une deuxième capacité disposée, du côté ligne abonné, en parallèle entre les deux lignes de transmission de la ligne. La partie passive du dispositif de filtrage selon l'invention constitue alors un filtre d'ordre 2.

Dans un exemple de réalisation, la partie active présente, lorsque le téléphone de l'abonné est décroché, une fonction de transfert d'ordre supérieur ou égal à 4, et les éléments actifs sont alimentés par un courant circulant sur la ligne téléphonique lorsque le téléphone de l'abonné est décroché. La partie active peut par exemple être une source de courant commandée par la tension à ses bornes.

La valeur des inductances peut être telle qu'elle est suffisamment élevée pour provoquer une chute de tension avant les éléments actifs de type ASIC pour que la tension aux bornes de chaque élément actif soit inférieure à 1 Volt.

Dans un exemple de réalisation, le dispositif de filtrage selon l'invention peut comporter un bloc passif correcteur disposé entre les deux lignes de transmission de la ligne, le bloc passif correcteur pouvant être composé d'une résistance et d'une capacité disposées en série.

Enfin, il est important de préciser que le dispositif de filtrage passe-bas selon l'invention peut être indifféremment disposé dans le central téléphonique ou chez l'abonné.

L'invention et ses différentes applications seront mieux comprises à la lecture de la description qui suit et à l'examen des figures qui l'accompagnent. Celles-ci ne sont présentées qu'à titre indicatif et nullement limitatif de l'invention. Les figures montrent :

EP 1 470 641 B1

- à la figure 1, déjà décrite, une représentation de l'exploitation de la bande de fréquence en distribution ADSL ;
- à la figure 2, déjà décrite, une illustration du principe de la séparation des signaux basse fréquence et haute fréquence sur une ligne ADSL ;
- à la figure 3, déjà décrite, l'allure générale de la disposition de filtres sur une ligne téléphonique servant à transmettre des signaux phoniques et des signaux xDSL ;
- à la figure 4, déjà décrite, une modélisation d'une impédance caractéristique complexe d'une ligne téléphonique ;
- aux figure 5-a à 5-c, déjà décrites, des exemples de filtres passifs utilisés dans l'état de la technique ;
- à la figure 6, une illustration du dispositif de filtrage passe-bas selon l'invention ;
- à la figure 7, une courbe illustrant la valeur de l'impédance de chaque composant actif en fonction de la fréquence des signaux reçus ;
- aux figures 8-a et 8-b, une fonction de transfert schématique du dispositif de filtrage selon l'invention et des blocs passifs et actifs le composant.

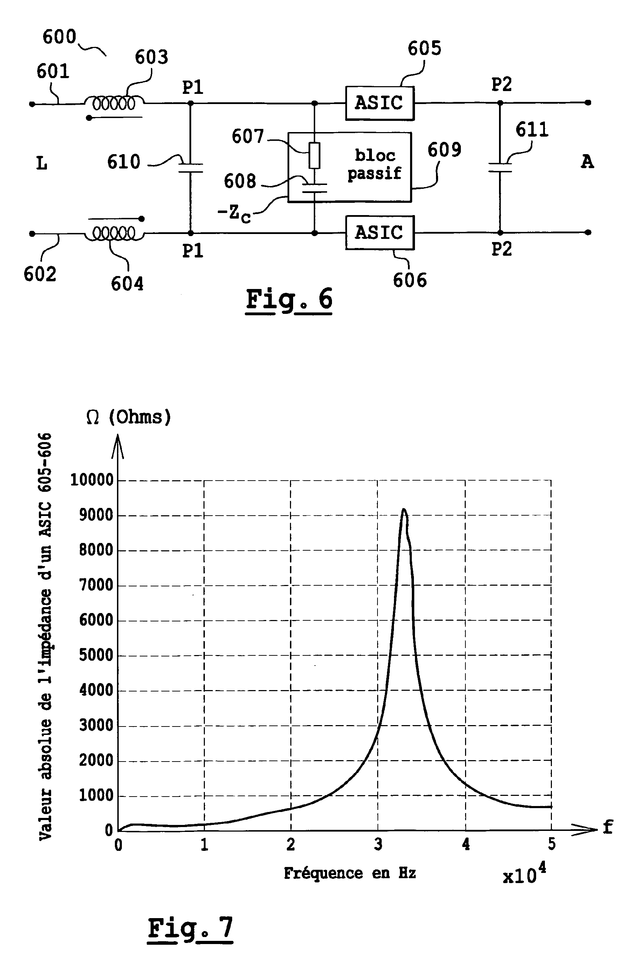

La figure 6 représente la structure générale d'un dispositif de filtrage passe-bas 600 de l'invention. Elle sera décrite dans le cas où il est placé du côté abonné A de la ligne. Il pourrait cependant être disposé du côté central téléphonique. Sur cette figure, on retrouve une ligne téléphonique classique L, composée d'une première ligne de transmission 601, appelée brin A ou ligne TIP, et d'une deuxième ligne de transmission 602, appelée brin B ou ligne RING. Sur chaque ligne de transmission 601 et 602, on dispose une inductance, respectivement 603 et 604. Ces deux inductances ont, pour des raisons de symétrie de la ligne téléphonique, la même valeur. Typiquement, cette valeur est de l'ordre de 17,5 mH (milliHenry). Sur chaque ligne de transmission, on dispose ensuite, en série avec l'inductance 603, respectivement 604, un composant actif de type ASIC 605, respectivement 606. Là encore, les deux ASIC sont semblables.

Les ASIC intervenant dans le dispositif selon l'invention ont une impédance, qui varie en fonction de la fréquence des signaux qui arrivent aux ASIC, conforme à la courbe représentée à la figure 7. Sur cette courbe, on peut observer que l'impédance des ASIC est quasiment nulle pour des fréquences voisines de 0 et pour les fréquences supérieures à 200 kHz, et qu'elle présente, en valeur absolue, un maximum pour des valeurs de fréquences voisines de 30 kHz, ce qui correspond à une valeur de la bande d'énergie inutilisée 107 de la figure 1. Typiquement, la valeur maximale de l'impédance obtenue par l'ASIC utilisé est voisine de 10 kiloOhms. Le niveau de réjection sera ainsi maximal pour les fréquences voisines de 30 kHz, la séparation des signaux basse fréquence et haute fréquence pouvant ainsi être assurée.

Dans un exemple de réalisation particulier, les ASIC 605 et 606 réalisant une fonction de transfert d'ordre 4 grâce à une impédance de la forme ;

$$Z(p) = Z0 \, ((A0 + A1p + A2p^2 + A3p^3 + A4p^4)/( B0 + B1p + B2 \, p^2 + B3p^3 + B4p^4))$$

où p est la variable de Laplace liée à la pulsation w par la formule p=jw, et où les valeurs des différents coefficients sont les suivantes :

Z0=5
A0=1
A1=1.9e-3
A2=2.6e-7
A3=3.9e-12
A4=3.56e-19
B0=1
B1=1.64e-4
B2=1.54e-8
B3=8.2e-15
B4=3.56e-19

Dans le dispositif de filtrage passe-bas selon l'invention, les ASIC constituant la partie active sont associés à une partie passive. Cette partie passive comprend notamment les inductances 603 et 604. Elle peut également comporter :

- une première capacité 610 qui relie les deux lignes de transmission 601 et 602 au niveau de points de connexion P1 situés entre les bobines 603 et 604 et les ASIC 605 et 606. Cette première capacité 610 permet essentiellement de compléter la partie passive du dispositif selon l'invention, qui, associée aux inductances 603 et 604, constitue alors un filtre passif d'ordre 2. La valeur de cette première capacité 610 est typiquement de 27 nF.

- une deuxième capacité 611 qui relie les deux lignes de transmission 601 et 602 au niveau de points de connexion P2 situés, sur chaque ligne de transmission, en sortie du filtre 600, du côté de l'abonné A. La deuxième capacité 611 sert essentiellement à filtrer un signal de bruit haute fréquence qui pourrait être généré par chaque ASIC. Elle contribue également au filtrage des signaux haute fréquence transmis selon les technologies xDSL. La valeur de cette deuxième capacité 611 est typiquement de 56 nF.

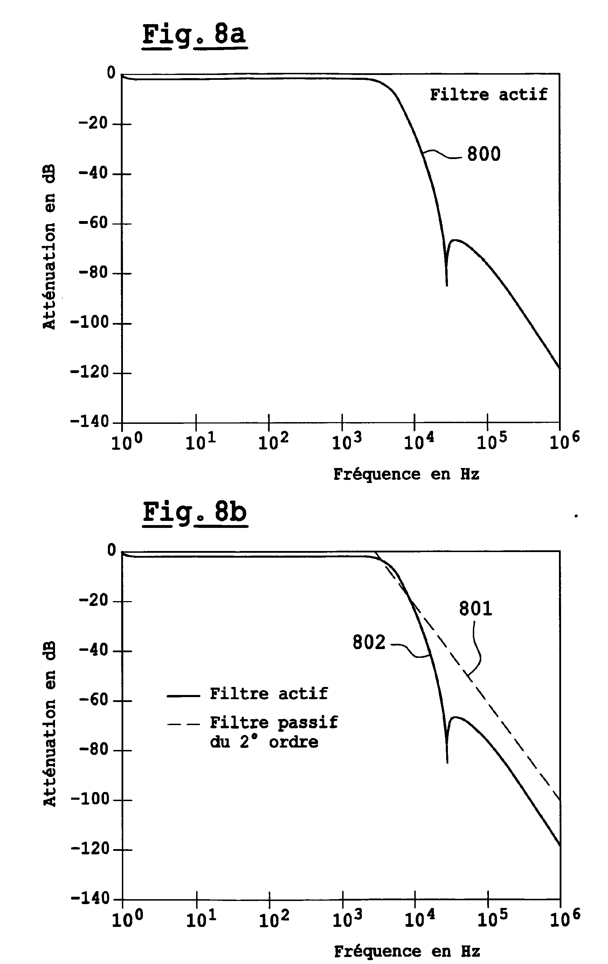

Une telle structure permet d'obtenir une fonction de transfert du dispositif de filtrage selon l'invention telle que représentée sur la figure 8-a. Sur cette figure, une courbe 800 est la synthèse des courbes représentées à la figure 8-b. Sur cette figure 8-b, une première courbe 801 en trait plein représente la fonction de transfert du filtre passif d'ordre 2 faisant intervenir les capacités 610 et 611 ainsi que les inductances 603 et 604. Il s'agit bien de la fonction de transfert d'un filtre du second ordre. Une deuxième courbe 802, en pointillé, représente la fonction de transfert des composants actifs 605 et 606. On retrouve bien un maximum d'atténuation pour les fréquences voisines de 30 kHz. Sur la figure 8-a, on voit bien que le maximum d'atténuation se retrouve dans une bande de fréquence voisine de 30 kHz, qui correspond à la bande de fréquence séparant le spectre des fréquences utilisées pour les communications phoniques et le spectre des fréquences utilisées pour les transferts de données selon les technologies xDSL.

La présence des composants passifs permet d'assurer une atténuation maximale au-delà de cette bande de fréquence. Il n'est ainsi pas nécessaire de prévoir des ASIC 605 et 606 présentant une impédance très élevée au-delà de cette bande de fréquence.

Selon les pays, le niveau de réjection dans cette bande de fréquence est variable ; il est par exemple de 65 dB pour les Etats-Unis d'Amérique et de 55 dB pour l'Europe. Ces différentes valeurs sont obtenues en programmant de façons différentes les ASIC. Ces derniers peuvent conserver d'un pays à l'autre la même structure ; il suffit d'ajuster les gains des différents étages les constituant, chaque étage étant essentiellement constitué d'une source de courant commandée en tension.

Dans un mode de réalisation particulier, un circuit de composants passifs, dit bloc passif 609, est disposé entre les deux lignes de transmission 601 et 602. Le bloc passif 609 est destiné à effectuer une opération d'adaptation d'impédance à la ligne L. Il permet de modifier les impédances d'entrée et de sortie du dispositif de filtrage selon l'invention. Il peut être par exemple composé d'une résistance 607 disposée en série avec une capacité 608. Une opération d'inversion de courant peut être effectuée au sein des ASIC 605 et 606 de telle sorte que le bloc passif 609 soit équivalent à une impédance négative -Zc.

Les contraintes rencontrées par le filtre selon l'invention, et les solutions apportées par celui-ci sont les suivantes :

Pour tenir compte de l'influence des signaux de sonnerie, qui sont des signaux alternatifs de 25 Hz à 50 Hz, d'amplitude maximale pouvant avoisiner 100 Volts, le filtre de l'invention prévoit que les deux ASIC soient disposés en série sur les lignes de transmission. En effet, du fait que l'impédance équivalente de chaque ASIC est seulement de quelques Ohms pour des fréquences de 25 Hz à 50 Hz, la disposition en série des ASICs assure que la différence de potentiel aux bornes de chaque ASIC est très inférieure à la tension des signaux de sonnerie qui avoisine 100 Volts. En effet la résistance de charge au moment de l'application des signaux de sonnerie est supérieure à plusieurs centaines de milliers d'Ohms. En conséquence, du fait que les différentes capacités 610 et 611 peuvent être considérées comme des circuits ouverts pour des fréquences de 25 Hz à 50 Hz, la tension maximum développée aux bornes de chaque ASIC est la moitié du ratio de l'impédance équivalente de l'ASIC pour ces fréquences à l'impédance de charge multiplié par la tension maximum de 100 V. Ainsi, cette tension n'excède pas quelques dizaines de millivolts pour ces fréquences.

D'autre part, du fait que les ASIC sont des sources de courant commandées en tension, ils assurent la bidirectionnalité des signaux de façon équivalente à un composant passif quelconque.

Toujours pour limiter ces tensions, il est nécessaire d'utiliser deux ASIC ayant deux substrats distincts, car implémenter deux ASIC sur un même substrat conduirait au risque de trouver sur ce substrat des différences de potentiel d'environ 100 Volts, qui détruiraient les ASIC. Pour des raisons de symétrie, ils présenteront la même structure avec les mêmes éléments.

L'influence des signaux ADSL, de fréquence 30 kHz à 1,1 MHz et d'amplitude maximale pouvant atteindre les 20 volts, sur la topologie du filtre est la suivante : il est nécessaire de prévoir les inductances 603 et 604 afin d'absorber une grande partie de l'amplitude en tension des signaux ADSL, ceci afin de préserver les ASIC qui sont réalisés dans une technologie CMOS à faible tension. Grâce à un choix judicieux des valeurs de ces inductances, on est assuré de ne pas avoir de tension supérieure à 1 Volt entre les bornes des ASIC. La présence de telles inductances permet notamment d'éviter des phénomène de non linéarité qui risqueraient d'être observés avec une technologie CMOS à bas voltage. En effet, si cette technologie accepte des tensions de l'ordre de 2,5 Volts par exemple, il est impératif de ne pas excéder 2 Volts pour éviter un écrêtage de courants résiduels ADSL dans la partie passe-bas du dispositif de filtrage. L'impédance des inductances 603, 604 doit être relativement élevée dès le début de la plage de fréquence adoptée pour la transmission de données selon les technologies xDSL afin de garantir une différence de potentiel faible aux bornes de chaque ASIC aux fréquences des signaux ADSL. Ceci va aussi de pair avec la nécessaire mise en haute impédance du dispositif de filtrage passe-bas selon l'invention aux fréquences ADSL.

L'influence des signaux continus, présents sur la ligne téléphonique, sur la structure du filtre est la suivante : afin de ne pas avoir à ajouter des sources d'énergie externes, les signaux continus circulant sur la ligne sont utilisés pour alimenter les ASIC. Deux cas de figure peuvent se présenter :

Dans un premier cas, le téléphone de l'abonné est "on hook", c'est à dire raccroché. Le téléphone est alors perçu sur la ligne comme un élément de très haute impédance, seul un micro-courant inférieur à 10 microAmpères circule sur la ligne téléphonique. Ce courant est insuffisant pour alimenter les deux ASIC 605 et 606, qui sont assimilables à des court-circuits. Les éléments passifs 603, 604, 610 et 611 constituent alors un simple filtre du second ordre calibré pour toujours présenter une impédance d'entrée suffisamment importante pour isoler l'abonné A des signaux ADSL. Ainsi, les signaux de signalisation, tels que les signaux de sonnerie, peuvent être acheminés sans distorsion jusqu'au combiné téléphonique de l'abonné.

Dans un second cas, le téléphone de l'abonné est "off hook", c'est à dire décroché. Le téléphone est alors perçu comme une impédance de l'ordre de 200 ohms à 430 ohms en courant continu, si bien qu'un courant de l'ordre de 20 mA peut circuler. Les différents composants actifs des ASIC peuvent alors être polarisés, si bien que le dispositif de filtrage représenté à la figure 6 constitue alors un filtre passe-bas du sixième ordre qui ne laisse passer que les signaux phoniques, assurant une réjection efficace des signaux ADSL.

## Revendications

1. Dispositif de filtrage passe-bas (600) utilisé sur une ligne téléphonique (L) composée d'une première ligne de transmission (601) et d'une deuxième ligne de transmission (602), susceptible de faire circuler simultanément, entre un central téléphonique (202) et un abonné (A) équipé d'au moins un téléphone (209), des premiers signaux correspondant à des services bande étroite analogique et/ou numérique, et des seconds signaux correspondant à des services large bande **caractérisé en ce que** :

   il comporte une partie active, constituée d'un premier élément actif de type ASIC (605), disposé en série sur la première ligne de transmission (601) et d'un deuxième élément actif de type ASIC (606) disposé en série sur la deuxième ligne de transmission (602), la partie active étant associée à une partie passive comportant notamment un premier élément passif (603) et un deuxième élément passif (604) de type inductance également disposés en série respectivement sur la première ligne de transmission (601) et sur la deuxième ligne de transmission (602) de la ligne (L), les inductances (603 ;604) précédant, du côté ligne (L), chaque élément actif (605 ;606) ;
   et **en ce que**

   - un courant insuffisant pour alimenter le premier élément actif et le deuxième élément actif circule sur la ligne téléphonique quand le téléphone est raccroché, le dispositif de filtrage constituant alors un filtre du second ordre;
   - un courant suffisant pour alimenter le premier élément actif et le deuxième élément actif, et pour polariser de composants actifs du premier élément actif et du deuxième élément actif, circule sur la ligne téléphonique quand le téléphone est décroché, le dispositif de filtrage constituant alors un filtre passe-bas d'ordre supérieur ou égal à quatre.

2. Dispositif de filtrage selon la revendication précédente **caractérisé en ce que** la partie passive comporte une première capacité (610) disposée, du côté ligne (L), en parallèle entre les deux lignes de transmission (601 ;602) de la ligne (L).

3. Dispositif de filtrage selon l'une des revendications précédentes **caractérisé en ce que** la partie passive comporte une deuxième capacité (611) disposée, du côté ligne abonné (A), en parallèle entre les deux lignes de transmission (601 ;602) de la ligne (L).

4. Dispositif de filtrage selon la revendication précédente **caractérisé en ce que** la partie active est une source de courant commandée par la tension à ses bornes.

5. Dispositif de filtrage passe-bas (600) selon l'une des revendications précédentes **caractérisé en ce que** les éléments actifs (605 ;606) sont alimentés par un courant circulant sur la ligne téléphonique (L) lorsque le téléphone (209) de l'abonné (A) est décroché.

**6.** Dispositif de filtrage passe-bas (600) selon l'une des revendications précédentes **caractérisé en ce que** la valeur des inductances (603 ;604) est suffisamment élevée pour provoquer une chute de tension avant les éléments actifs de type ASIC (605 ;606) pour que la tension aux bornes de chaque élément actif soit inférieure à 1 Volt.

**7.** Dispositif de filtrage passe-bas (600) selon l'une des revendications précédentes **caractérisé en ce qu'**il comporte un bloc passif (609) correcteur disposé entre les deux lignes de transmission (601 ;602) de la ligne (L).

**8.** Dispositif de filtrage passe-bas (600) selon la revendication précédente **caractérisé en ce que** le bloc passif (609) correcteur est composé d'une résistance (607) et d'une capacité (608) disposées en série.

**9.** Dispositif de filtrage passe-bas (600) selon l'une des revendications précédentes **caractérisé en ce qu'**il est disposé dans le central téléphonique (202) et/ou chez l'abonné (A).

## Claims

**1.** A low-pass filtering device (600) used on a telephone line (L) consisting of a first transmission line (601) and a second transmission line (602), capable of circulating simultaneously, between a telephone exchange (202) and a subscriber (A) equipped with at least one telephone (209), first signals corresponding to analogue and/or digital narrowband services, and second signals corresponding to broadband services, **characterized in that**:

it includes an active part, consisting of a first active ASIC-type element (605), arranged in series on the first transmission line (601), and a second active ASIC-type element (606) arranged in series on the second transmission line (602), the active part being associated to a passive part, comprising in particular a first passive inductance-type element (603) and a second passive inductance-type element (604), also arranged in series on the first transmission line (601) and the second transmission line (602) of the line (L) respectively, the inductors (603; 604) preceding, from the line side (L), each active element (605; 606);
and **in that**

- a current too low to power the first active element and the second active element circulates over the telephone line when the telephone is hung-up, the filtering device therefore constituting a second order filter;
- a current high enough to power the first active element and the second active element, and to polarise the active components of the first active element and of the second active element, circulates over the telephone line when the telephone is picked up, the filtering device therefore constituting a low-pass filter with an order higher than or equal to four.

**2.** A filtering device according to the previous claim, **characterized in that** the passive part comprises a first capacitor (610) arranged, from the line side (L), in parallel between the two transmission lines (601; 602) of the line (L).

**3.** A filtering device according to one of the previous claims, **characterized in that** the passive part comprises a second capacitor (611) arranged, from the subscriber side (A), in parallel between the two transmission lines (601; 602) of the line (L).

**4.** A filtering device according to the previous claim, **characterized in that** the active part is a source of current controlled by the voltage across its terminals.

**5.** A low-pass filtering device (600) according to one of the previous claims, **characterized in that** the active elements (605; 606) are powered by a current circulating over the telephone line (L) when the telephone (209) of the subscriber (A) is picked up.

**6.** A low-pass filtering device (600) according to one of the previous claims, **characterized in that** the value of the inductors (603; 604) is high enough to cause a drop in voltage before the ASIC-type active elements (605; 606) so that the voltage across the terminals of each active element is lower than 1 Volt.

**7.** A low-pass filtering device (600) according to one of the previous claims, **characterized in that** it comprises a correcting passive block (609) arranged between the two transmission lines (601; 602) of the line (L).

8. A low-pass filtering device (600) according to the previous claim, **characterized in that** the correcting passive block (609) is comprised of a resistor (607) and a capacitor (608) arranged in series.

9. A low-pass filtering device (600) according to one of the previous claims, **characterized in that** it is arranged within the telephone exchange (202) and/or on the subscriber's (A) premises.

**Patentansprüche**

1. Vorrichtung zur Tiefpassfilterung (600), die in einer Telefonleitung (L) verwendet wird, die aus einer ersten Übertragungsleitung (601) und aus einer zweiten Übertragungsleitung (602) besteht, die imstande ist, zwischen einer Telefonzentrale (202) und einem Abonnenten (A), der zumindest mit einem Telefon (209) ausgerüstet ist, gleichzeitig erste Signale entsprechend analogen und/ oder digitalen Schmalbandangeboten und zweite Signale, die Breitbandangeboten entsprechen, zu übertragen, **dadurch gekennzeichnet, dass**:

sie einen aktiven Abschnitt enthält, der aus einem ersten aktiven Element vom Typ ASIC (605) besteht, das in Reihe auf der ersten Übertragungsleitung (601) angeordnet ist, und aus einem zweiten aktiven Element vom Typ ASIC (606), das in Reihe auf der zweiten Übertragungsleitung (602) angeordnet ist, wobei der aktive Abschnitt einem passiven Abschnitt zugeordnet wird, der vor allem ein erstes passives Element (603) und ein zweites passives Element (604) vom Typ Induktivität enthält, die ebenfalls in Reihe jeweils auf der ersten Übertragungsleitung (601) und auf der zweiten Übertragungsleitung (602) der Leitung (L) angeordnet sind, wobei die Induktivitäten (603; 604) auf Seiten der Leitung (L) jedem aktiven Element (605; 606) vorangehen; und **dadurch**, dass

- ein für die Versorgung des ersten aktiven Elements und des zweiten aktiven Elements unzureichender Strom durch die Telefonleitung fließt, wenn das Telefon aufgelegt ist, wobei die Filtervorrichtung dabei einen Filter der zweiten Ordnung darstellt;
- ein für die Versorgung des ersten aktiven Elements und des zweiten aktiven Elements und für die Polarisierung aktiver Komponenten des ersten aktiven Elements und des zweiten aktiven Elements ausreichender Strom durch die Telefonleitung fließt, wenn das Telefon abgehoben ist, wobei die Filtervorrichtung dabei einen Tiefpassfilter in der Größenordnung von größer oder gleich vier darstellt.

2. Filtervorrichtung nach dem vorherigen Anspruch, **dadurch gekennzeichnet, dass** der passive Abschnitt eine erste Kapazität (610) enthält, die auf Seiten der Leitung (L) parallel zwischen den beiden Übertragungsleitungen (601; 602) der Leitung (L) angeordnet ist.

3. Filtervorrichtung nach einem der vorherigen Ansprüche, **dadurch gekennzeichnet, dass** der passive Abschnitt eine zweite Kapazität (611) enthält, die auf Seiten der Abonnentenleitung (A) parallel zwischen den beiden Übertragungsleitungen (601; 602) der Leitung (L) angeordnet ist.

4. Filtervorrichtung nach dem vorherigen Anspruch, **dadurch gekennzeichnet, dass** der aktive Abschnitt eine Stromquelle ist, die durch die Spannung an seinen Klemmen gesteuert wird.

5. Vorrichtung zur Tiefpassfilterung (600) nach einem der vorherigen Ansprüche, **dadurch gekennzeichnet, dass** die aktiven Elemente (605; 606) durch einen Strom versorgt werden, der durch die Telefonleitung (L) fließt, wenn das Telefon (209) des Abonnenten (A) abgehoben ist.

6. Vorrichtung zur Tiefpassfilterung (600) nach einem der vorherigen Ansprüche, **dadurch gekennzeichnet, dass** der Wert der Induktivitäten (603; 604) hoch genug ist, um einen Spannungsabfall vor den aktiven Elementen vom Typ ASIC (605; 606) hervorzurufen, damit die Spannung an den Klemmen eines jeden aktiven Elements unter 1 Volt liegt.

7. Vorrichtung zur Tiefpassfilterung (600) nach einem der vorherigen Ansprüche, **dadurch gekennzeichnet, dass** sie einen passiven Korrekturblock (609) enthält, der zwischen den beiden Übertragungsleitungen (601; 602) der Leitung (L) angeordnet ist.

8. Vorrichtung zur Tiefpassfilterung (600) nach dem vorherigen Anspruch, **dadurch gekennzeichnet, dass** der passive Korrekturblock (609) aus einem Widerstand (607) und einer Kapazität (608) besteht, die in Reihe angeordnet sind.

9. Vorrichtung zur Tiefpassfilterung (600) nach einem der vorherigen Ansprüche, **dadurch gekennzeichnet, dass** sie in der Telefonzentrale (202) und/ oder beim Abonnenten (A) angeordnet ist.

Spectre
de
puissance

Fig. 1

100

102

107

Spectre
vocal

103

104

105

101

4khz   4,2khz

4,3khz

106

106

1,1Mhz   Echelle des
frequences

208   207   201   202   205   206   204

200

L

Splitter

Splitter

D
S
L
A
M

Internet

209   203

Fig. 2

201   202

HF   HF

BF   L   BF

Fig. 3

**Fig. 4**

**Fig. 5a**

**Fig. 5b**

**Fig. 5c**

**Fig. 6**

Fréquence en Hz       x10$^4$

**Fig. 7**

## Fig. 8a

## Fig. 8b